# EUROPEAN PATENT APPLICATION

(11) **EP 3 547 087 A1**
(43) Date of publication of application: **02.10.2019**
(21) Application number: 17825088.2
(22) Date of filing: 19.05.2017
(51) Int. Cl.: G06F 3/041, G02F 1/1333, G02F 1/1335

(54) **TOUCH-SENSING SUBSTRATE, TOUCH-SENSING SCREEN AND MANUFACTURING METHOD THEREOF, AND DISPLAY APPARATUS**

(30) Priority: 24.11.2016 CN 201611043895
(71) Applicant: BOE Technology Group Co., Ltd., Beijing Anhui 100015 (CN); Hefei Xinsheng Optoelectronics Technology Co., Ltd., Xinzhan Industrial Park Hefei Anhui 230012 (CN)
(72) Inventor: WANG, Jing, Beijing 100176 (CN); HU, Ming, Beijing 100176 (CN); ZHANG, Ming, Beijing 100176 (CN); XIE, Xiaodong, Beijing 100176 (CN); ZHU, Yu, Beijing 100176 (CN); ZHENG, Qitao, Beijing 100176 (CN); ZHANG, Guiyu, Beijing 100176 (CN); LI, Dong, Beijing 100176 (CN)
(74) Representative: Gesthuysen Patent- und Rechtsanwälte
(86) International application number: PCT/CN2017/085060
(87) International publication number: WO 2018/094985

(57) **Abstract**

A touch screen includes: an array substrate and a color filter substrate disposed opposite to each other, the color filter substrate including an active area and a bezel area located at a periphery of the active area; a touch element layer disposed at a side of the color filter substrate facing away from the array substrate or a side of the color filter substrate facing towards the array substrate, the touch element layer including a number of metal pads disposed in its peripheral region; and a light shielding layer disposed on a side of at least one of the number of metal pads facing away from the array substrate. The bezel of the touch screen is narrow, so that a larger screen can be housed in a limited machine body, with cost advantages and a stylish appearance.

## Description

### RELATED APPLICATION

The present application claims the priority of a Chinese patent application No. 201611043895.2 filed on November 24, 2016, which is incorporated herein by reference in its entirety.

### FIELD OF THE DISCLOSURE

The present disclosure relates to display technical field, and more particularly to a touch substrate, a touch screen, and a manufacturing method thereof.

### BACKGROUND OF THE DISCLOSURE

Touch screen display technology is becoming more and more popular. According to different sensing methods, touch screens can be classified into four categories: resistive, capacitive, infrared and acoustic. At present, the resistive and capacitive categories have relatively larger market share. With the recognition and acceptation of touch experience, the capacitive touch screen is gradually replacing the resistive touch screen.

The method of integrating the touch panel function with the LCD panel mainly includes the "In-cell" method and the "On-cell" method. In-cell method refers to the method of embedding the touch panel function into the liquid crystal pixel; the In-cell touch screen is in the category of embedded touch screen, wherein a touch device layer is arranged between a color filter substrate and an array substrate. The On-cell method refers to the method of embedding the touch panel function between the color filter substrate and a polarizer; the on-cell touch screen is in the category of add-on touch screen, where the touch device layer is embedded between the color filter substrate and the polarizer.

With the rapid growth of the touch screen, the requirements on the touch screen, such as a thickness of the touch screen, touch sensitivity and a width of the bezel, are getting higher and higher. The solutions with a narrow bezel or no bezel have also become more and more attractive. In order to accommodate a larger screen in a limited machine body and increase the effective utilization of the display, it has become a mainstream to reduce the bezel width and realize a narrow bezel design.

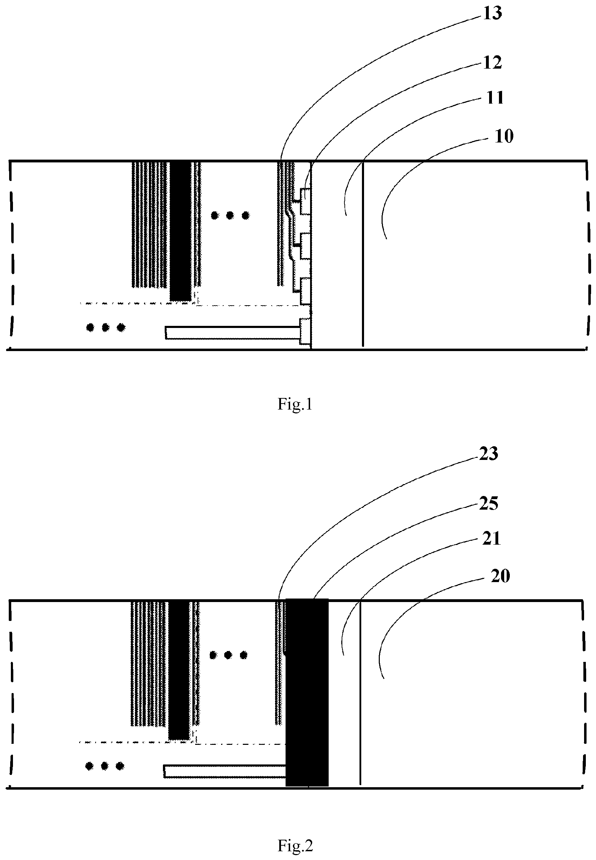

Taking the On cell display as an example, as shown in Fig. 1, generally, in a touch element layer at a periphery of an active area (Active Area, which is an area in which characters, graphics, or images can be displayed, referred to as AA for abbreviation) 10 of a liquid display module, there are metal pads (also known as bonding pads, referred to as pad for abbreviation) 12 and connection leads 13 and the like. In order to prevent exposure of the metal pad, that is, to avoid user from seeing the metal pads from the outside of the liquid crystal display, the spacing 11 between the metal pad 12 and the active area 10 needs to be set large. Excessive spacing 11 accordingly causes the bezel of the display to be too large, affecting the appearance of the display.

### SUMMARY OF THE DISCLOSURE

An embodiment of the present disclosure provides a touch screen, which includes: an array substrate and a color filter substrate disposed opposite to each other, the color filter substrate including an active area and a bezel area at a periphery of the active area; a touch element layer disposed on a side of the color filter substrate facing away from the array substrate or a side of the color filter substrate facing towards the array substrate, the touch element layer including a plurality of metal pads in its peripheral region; and a light shielding layer disposed on a side of at least one of said plurality of metal pads facing away from the array substrate.

Because the touch screen is provided with metal pads in its touch element layer, and when human eyes are located directly above the screen and view at an angle inwardly from the outside of the bezel, a bright reflection from a part of the metal pad closest to the display screen can be seen. When the width of the bezel of the touch screen is reduced below a few millimeters, it is necessary to separate the metal pad from the active area of the touch screen by approximately 1.5 mm in order to avoid users seeing the metal pad in the touch element layer from the outside. For the total width of the bezel of a few millimeters, the 1.5 mm spacing width hinders the bezel becoming narrower. In the above-described technical solution according to an embodiment of the present disclosure, by providing a light-shielding layer to cover at least one metal pad (having the exposing risk) located in the peripheral region, it is possible to avoid the visual exposure of the pads, that is, to avoid the metal pads to be seen from the outside, and at the same time reduce the spacing between the metal pads and the active area of the touch screen. Thus, compared to the prior art touch screen, a touch screen with a narrow bezel design according to the present embodiment can accommodate a larger screen in a limited machine body size, with cost advantage and stylish an appearance.

In an aspect of the embodiment of the present disclosure, the area of the light shielding layer can cover all of the metal pads in the peripheral region.

In an aspect of the embodiment of the present disclosure, the width of the bezel area is 2 to 3.8 mm.

In an aspect of the embodiment of the present disclosure, the spacing between the light shielding layer and the active area is less than 1.0 mm, preferably 0.4-0.9 mm, more preferably 0.5-0.8 mm, most preferably 0.5-0.6 mm.

In an aspect of the embodiment of the present disclosure, the light shielding layer is made of a photoresist material. For example, the light shielding layer is a black matrix layer, a black ink layer, a gray ink layer or a white ink layer. The color of the shielding layer depends on the color of the touch screen housing (or bezel). If the touch screen housing (or bezel) is black, the shielding layer is black; if the touch screen housing (or bezel) is white, the shielding layer is white, so as to reduce the color difference and to overcome the problem of easy visual exposure. Wherein, the black matrix accuracy is high but its cost is also high, the black ink accuracy is low and its cost is also low.

In an aspect of the embodiment of the present disclosure, the at least one metal pad in the peripheral region is pad(s) for connecting ground wires.

In order to achieve the above object, the embodiment of the present disclosure also provides another touch screen, which comprises: an array substrate and a color filter substrate disposed opposite to each other, the color filter substrate including an active area and a bezel area at the periphery of the active area; and a touch element layer disposed on a side of the color filter substrate facing away from the array substrate or a side of the color filter substrate facing toward the array substrate, wherein the touch element layer comprises an intermediate region and a peripheral region, the peripheral region including a plurality of ITO pads instead of metal pads. The intermediate region comprises metal pads and/or ITO pads.

According to this technical solution, it is possible to avoid the visual exposure of the metal pads, that is, to avoid the metal pads to be seen from the outside, by replacing the metal pads having exposure risk in the peripheral region of the touch element layer with the ITO material pads. The narrow bezel design according to the embodiment of the present disclosure can accommodate a larger screen in a limited machine body size, with cost advantages and a visually pleasing touch screen.

The present embodiment also provides a method of manufacturing a touch screen, comprising the steps of: preparing an array substrate and a color filter substrate, the color filter substrate including an active area and a bezel area located at a periphery of the active area; preparing a touch element layer on a side of the color filter substrate facing away from the array substrate or on a side of the color filter substrate facing towards the array substrate, the touch element layer including a plurality of metal pads in the peripheral region; and providing a light shielding layer on a side of the plurality of metal pads facing away from the array substrate.

The present embodiment also provides another method of manufacturing a touch screen, comprising the steps of: preparing an array substrate and a color filter substrate, the color filter substrate including an active area and a bezel area located at a periphery of the active area; and preparing a touch element layer on a side of the color filter substrate facing away from the array substrate or a side of the color filter substrate facing toward the array substrate side, the touch element layer including an intermediate region and a peripheral region, the peripheral region including a plurality of ITO pads instead of metal pads.

The present embodiment also provides a touch substrate, comprising: a base substrate; a touch element layer disposed on the base substrate, the touch element layer including a plurality of metal pads in its peripheral region; and a light shielding layer disposed on a side of at least one of said plurality of metal pads facing away from the base substrate.

According to an aspect of the present disclosure, the area of the light shielding layer covers all the metal pads in the peripheral region.

An embodiment of the present disclosure also provides a display device including the touch substrate or the touch screen as described above and a drive device for driving the touch substrate or the touch screen.

### BRIEF DESCRIPTION OF THE DRAWINGS

Hereinafter, specific embodiments of the touch screen according to the present disclosure will be described by way of example with reference to the accompanying drawings. In addition, it should be noted that the description does not limit the scope of the disclosure in any way, wherein:
Fig. 1 schematically shows a front view of a partial structure of a touch screen in prior art that does not solve the problem of exposed metal pads.
Fig. 2 schematically shows a front view of a partial structure of a touch screen according to an embodiment of the present disclosure, wherein the problem of the metal pad exposure is solved by providing a light shielding layer on the peripheral region of the touch element layer.
Fig.3 schematically shows a front view of a partial structure of a touch screen according to a second embodiment of the present invention in which the metal pads (having exposing risk) in the peripheral region of the touch element layer are replaced with ITO material pads to solve the problem of metal pad exposure.
Fig.4 is a schematic cross-sectional view of an on-cell touch screen in which the problem of the metal pad exposure is solved by providing a light-shielding layer on the peripheral area of the touch element layer.
Figure 5 is a schematic cross-sectional view of an on-cell touch screen in which the metal pad exposure problem is solved by replacing the metal pads in the peripheral area of the touch element layer with ITO material pads.
Fig.6 and 7 are schematic views showing steps in a method of manufacturing a touch screen according to a second embodiment and a first embodiment of the present disclosure, respectively.

### DETAILED DESCRIPTION OF THE DISCLOSURE

### First embodiment

Referring to Fig. 1, Fig. 2, and Fig. 4 altogether, the touch screen according to the first embodiment of the present disclosure includes an array substrate 41 and a color filter substrate 43 disposed opposite to each other, and a liquid crystal layer 42 sandwiched therebetween.

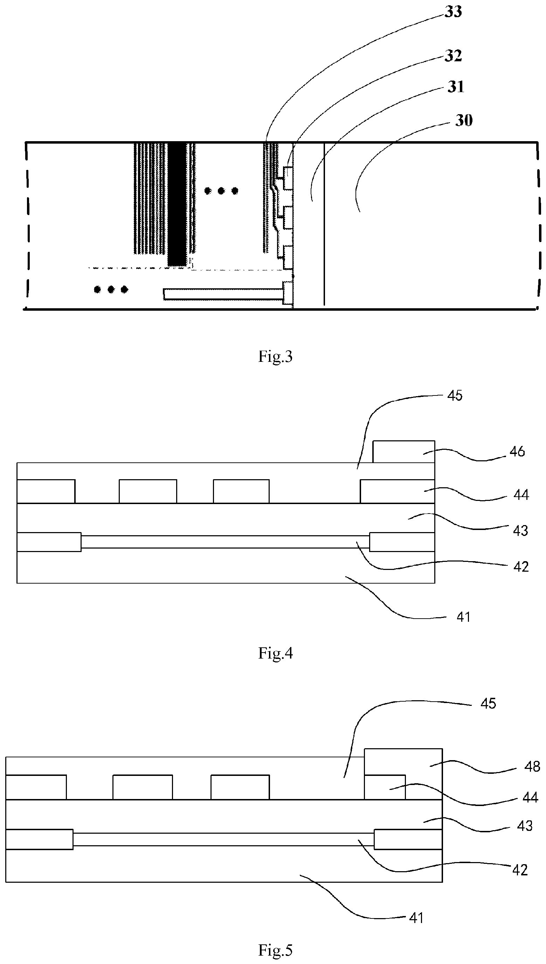

For the sake of simplicity, taking the on-cell touch screen as an example, as shown in Fig.4, the touch element layer 45 is provided on a side of the color filter substrate 43 facing away from the array substrate 41. It should be noted that the inventive concept and the inventive idea also apply to the in-cell touch screen wherein the touch element layer is disposed on a side of the color filter substrate facing the array substrate.

The color filter substrate 43 includes an active area 20 and a bezel area 21 located at the periphery of the active area 20, and a touch element layer 45 disposed on the side of the color filter substrate 43 facing away from the array substrate 41. Wherein the touch element layer 45 includes an intermediate region and a peripheral region and is provided with a plurality of metal pads 44. At least one meal pad (with exposure risk) located in the peripheral region on the side facing away from the array substrate 41 is provided with a light shielding layer 25. According to one aspect of the present disclosure, only the at least one metal pad in the peripheral region is provided with a light shielding layer 25. The at least one metal pad in the peripheral region is pad(s) for connecting leads 23 or ground wires.

The width of the bezel area 21 is 2 to 3.8 mm. The spacing between the light shielding layer and the active area 20 is less than 1.0 mm, preferably 0.4-0.9 mm, more preferably 0.5-0.8 mm, most preferably 0.5-0.6 mm.

The light shielding layer 25 is made of a photoresist material. For example, the light shielding layer is a black matrix layer, a black ink layer, a gray ink layer or a white ink layer.

In this embodiment, by forming a BM layer or screen printing a black ink layer, a gray ink layer or a white ink layer on the periphery of the on cell or in cell touch device layer to cover the metal pad so as to solve the metal pad exposure problem caused by narrowing the spacing between the metal pad and the AA of the liquid crystal display module, a narrow bezel design can be realized. By using the BM or ink to cover the metal Pad, the preset spacing for avoiding the metal pad being exposed when a user viewing it at an angle, the spacing preserved for the consideration of attaching accuracy and tape size and the like can be omitted, so that the spacing between the metal pad and the AA of the liquid display module can be reduced and the exposure of the metal pad can be avoided, and therefore a narrow bezel design can be realized finally. Since this application solves the problem of metal pad exposure, the width of the bezel can be reduced by one third to one quarter.

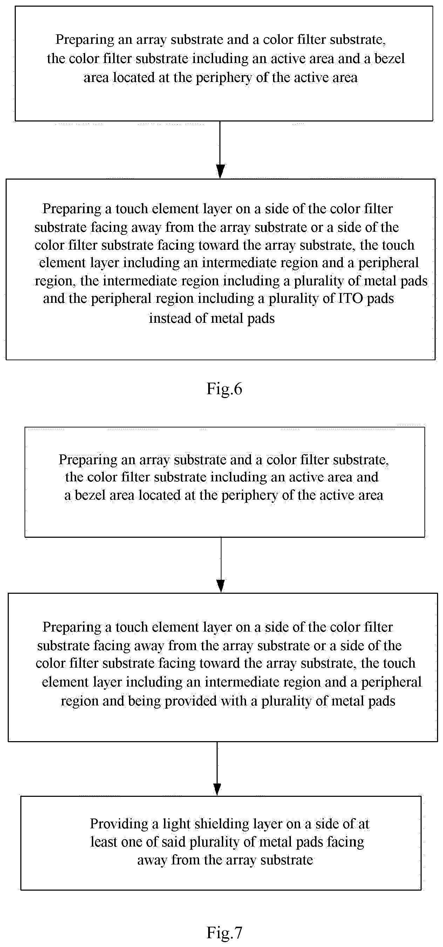

Also referring to Fig. 7, the manufacturing method of the touch screen mainly comprises the following steps: S1, preparing an array substrate 41 and a color filter substrate 43, the color filter substrate 43 including an active area 20 and a bezel area 21 at the periphery of the active area 20; S2, preparing a touch element layer 45 on the side of the color filter substrate 43 facing away from the array substrate 41 or the side of the color filter substrate 43 facing toward the array substrate, the touch element layer 45 including an intermediate region and a peripheral region and is provided with a plurality of metal pads 44; and S3, disposing light shielding layer(s) 25, 26 on a side of the at least one metal pad in the peripheral region facing away from the array substrate 41.

Specifically, according to the first embodiment, the detailed steps of manufacturing the On cell touch screen are as follows:
(1) preparing an array substrate and a color filter substrate, and then forming a liquid crystal cell by aligning the array substrate and the color filter substrate;
(2) preparing a touch element layer on the color filter substrate, including forming metal traces and a metal pad layer, wherein the main process includes metal plating, photoresist coating, exposing, developing, etching, forming the required metal traces and the metal pad layer;
(3) forming an OC layer, wherein the main process includes applying glue, exposing, developing, and forming the required OC layer pattern;
(4) forming a BM layer or screen printing black ink after cutting into small pieces to cover the metal pad.

Specifically, according to the first embodiment, the detailed steps of manufacturing the in cell touch screen are as follows:
(1) preparing an array substrate and a color filter substrate; and preparing a touch element layer in the liquid crystal pixels of the color filter substrate, including forming metal traces and a metal pad layer, and the main process including metal plating, applying photoresist, exposing, developing, etching, forming the required metal traces and the metal Pad layer;
(2) forming an OC layer, the main process including applying glue, exposing, developing, and forming the required OC layer pattern;
(3) forming a BM layer or screen printing black ink after cutting into small pieces to cover the metal pad.

In the traditional touch screen, because the metal pads in the touch element layer is not shielded, when human eyes are located directly above the screen and look at an angle inwardly from the outside of the bezel, a bright reflection of a part of the metal pad closest to the display screen can be seen. When the width of the bezel of the touch screen is reduced below a few millimeters, it is necessary to separate the metal pad from the active area of the touchscreen by approximately 1.5 mm in order to avoid seeing the metal pad in the touch element layer from the outside. For the total width of the bezel of a few millimeters, the 1.5 mm spacing width hinders the bezel becoming narrower. On the contrary, in the above-described technical solution according to the embodiment of the present disclosure, by providing light-shielding layers 25, 46 to cover at least one metal pad (having exposing risk) located in the peripheral region, it is possible to avoid the visual exposing of the pads, that is, to avoid the metal pads to be seen from the outside, and at the same time reduce the spacing between the metal pads and the active area of the touch screen. Thus, compared to the prior art touch screen, the touch screen with a narrow bezel design according to the present embodiment can accommodate a larger screen in a limited body size, with a cost advantage and a stylish appearance.

### Second embodiment

Referring to Fig. 1, Fig. 3, and Fig. 5 altogether, the touch screen according to the second embodiment of the present disclosure includes an array substrate 41 and a color filter substrate 43 disposed opposite to each other, and a liquid crystal layer 42 sandwiched therebetween.

For simplicity, taking the on-cell touch screen as an example, as shown in Fig.5, the touch element layer 45 is provided on a side of the color filter substrate 43 facing away from the array substrate 41. It should be noted that the inventive concept and the inventive idea also apply to the in-cell touch screen wherein the touch element layer is disposed on the side of the color filter substrate facing the array substrate.

The color filter substrate 43 includes: an active area 30 and a bezel area 31 located at the periphery of the active area 30, and a touch element layer 45 disposed on the side of the color filter substrate 43 facing away from the array substrate 41, wherein the touch element layer 45 includes an intermediate region and a peripheral region. The intermediate region includes a plurality of metal pads and the peripheral region includes a plurality of ITO pads 32. Comparing with the first embodiment, the technical solution of the second embodiment replaces the metal pad in the peripheral region with pads made of transparent ITO material, avoiding the bright reflection caused by the metal pads. Therefore, when human eyes are located directly above the display screen and look inwards from the outside of the bezel at an angle, no bright reflection from the metal pad will be seen so that the bezel can be designed to be narrow. Comparing with the first embodiment, the second embodiment does not need to provide an additional shielding layer so that the process step of forming the shielding layer can be omitted.

The width of the bezel area 31 is 2 to 3.8 mm. The spacing between the at least one ITO pad in the peripheral region and the active area 30 is less than 1.0 mm, preferably 0.4-0.9 mm, more preferably 0.5-0.8 mm, and most preferably 0.5-0.6 mm.

In the second embodiment, by replacing the metal pad having exposure risk with ITO Pads (Indium Tin Oxide pad), the metal trace is overlapped with the ITO Pads, and the optical film at the overlapped area is hollowed out so that the electrical circuit is completed, in order to shorten the spacing between the Pad and the AA of the LCD module, thereby to achieve narrow bezel design. Since this application solves the problem of metal pad exposure, the width of the bezel can be reduced by one third to one quarter.

Also referring to Fig. 6, the manufacturing method of the touch screen mainly comprises the following steps: S1, preparing an array substrate 41 and a color filter substrate 43, the color filter substrate 43 including an active area 30 and a bezel area 31 at the periphery of the active area 30; S2, preparing a touch element layer 45 on the side of the color filter substrate 43 facing away from the array substrate 41 or on the side of the color filter substrate 43 facing toward the array substrate. The touch element layer 45 includes an intermediate region and a peripheral region. The intermediate regions includes a plurality of metal pads, and the peripheral region includes a plurality of ITO pads 32.

Specifically, according to the second embodiment, the detailed steps of manufacturing the On cell touch screen are as follows:
(1) preparing an array substrate and a color filter substrate, and then forming a liquid crystal cell by aligning the array substrate and the color filter substrate;
(2) preparing a touch element layer on the color filter substrate, including forming metal traces and a metal pad layer, wherein the main process includes metal plating, resist coating, exposing, developing, etching, forming the required metal traces and the metal pad layer;
(3) forming an OC layer, wherein the metal trace is overlapped with the ITO Pads, and the optical film at the overlapped area is hollowed out, and wherein the main process includes applying glue, exposing, developing, thereby forming the required OC layer pattern;
(4) forming an ITO pattern and an ITO pad layer, the pad and metal traces are overlapped, the main process including ITO film plating, applying photoresist, exposing, developing, etching, thereby forming the required ITO pattern and ITO Pad layer

Specifically, according to the second embodiment, the detailed steps of manufacturing the in cell touch screen are as follows:
(1) preparing an array substrate and a color filter substrate; and preparing a touch element layer in the liquid crystal pixels of the color filter substrate, including forming metal traces layer, and the main process including metal film plating, applying photoresist, exposing, developing, etching, forming the required metal traces and the metal Pad layer;
(2) forming an OC layer, at the overlapped area of the metal trace and the ITO Pads, the OC layer is hollowed, the main process including applying glue, exposing, developing, thereby forming the required OC layer pattern;
(3) forming an ITO pattern and an ITO pad layer, the Pad and the metal traces are overlapped, the main process including ITO film plating, applying photoresist, exposing, developing, etching, thereby forming the required ITO pattern and ITO Pad layer.

In the traditional touch screen, because the metal pads in the touch element layer is not shielded, when human eyes are located directly above the screen and look at an angle inwardly from the outside of the bezel, a bright reflection of a part of the metal pad closest to the display screen can be seen. When the width of the bezel of the touch screen is reduced below a few millimeters, it is necessary to separate the metal pad from the active area of the touch screen by approximately 1.5 mm in order to avoid seeing the metal pad in the touch element layer from the outside. For the total width of the bezel of a few millimeters, the 1.5 mm spacing width hinders the bezel becoming narrower. On the contrary, in the above-described technical solution according to the embodiment of the present disclosure, it is possible to avoid the visual exposure of the metal pads, that is, to avoid the metal pads to be seen from the outside, by replacing the metal pads having exposure risk in the peripheral region of the touch element layer with the ITO material pads 32, 48. Comparing with the touch screen in prior art, the narrow bezel design according to the embodiment of the present disclosure can accommodate a larger screen in a limited machine body size, which has a cost advantage and stylish appearance.

In the above-mentioned two solutions to solve the metal pad exposure, the first embodiment covers the metal pads having exposure risk in the periphery with a shielding layer, without requiring redesigning the manufacturing process, which is simple and convenient for the designer; and the second embodiment replaces the metal pads having exposure risk in the periphery with IRO pads, which requires redesigning the manufacturing process, and therefore is relatively complex for the designer.

It should be understood that although the basic constructions, operational mechanisms, various features and advantages as well as details of the disclosure have been set forth in the foregoing description, the description is merely exemplary and the disclosure is not limited to the above specific embodiments. For example, as for the touch substrate as claimed in the present disclosure, the light shielding layer for covering the metal pads may also be additionally provided on the side of the metal pads facing toward the base substrate; as for the touch screen claimed in the present disclosure, a light-shielding layer may also be provided on the side of the metal pads in the peripheral region facing toward the array substrate. By disposing light shielding layers on both sides, on the one hand, the metal pad exposure risk can be further lowered; on the other hand, it is also equally useful for two side display or transparent display.

The specific details of the present disclosure, particularly within the scope of the principle of the present disclosure, may be modified within the entire scope as interpreted by the claims in its broadest sense.

The phrase "a" or "an" in the claims of the present disclosure does not exclude the plural, which is merely intended to be illustrative and should not be construed as limiting the scope of the present disclosure.

Unless otherwise defined, all technical and scientific terms used in this specification have the same meaning as commonly understood by those skilled in the art to which this disclosure belongs.

It is should be understood that the organic light emitting display device and the packaging method of the present disclosure are not limited to those described above. Any person skilled in the art, having read the present disclosure, can make some variations and equivalents using the prior art without creative efforts, and all those variations and equivalents are within the scope of the claims of the present disclosure.

## Claims

1. A touch substrate, comprising:
a base substrate;
a touch element layer disposed on the base substrate, the touch element layer comprising a plurality of metal pads in its peripheral region; and
a light shielding layer provided on a side of at least one of said plurality of metal pads facing away from the base substrate.

2. The touch substrate according to claim 1, wherein an area of the light-shielding layer covers all the metal pads in the peripheral region

3. The touch substrate according to claim 1, wherein a spacing between the light shielding layer and an active area of the touch substrate is less than 1.0 mm.

4. The touch substrate according to claim 1, wherein a spacing between the light shielding layer and an active area of the touch substrate is 0.4 to 0.9 mm.

5. The touch substrate according to claim 1, wherein the spacing between the light shielding layer and an active area of the touch substrate is 0.5 to 0.8 mm.

6. The touch substrate according to claim 1, wherein the spacing between the light shielding layer and an active area of the touch substrate is 0.5 to 0.6 mm.

7. The touch substrate according to any one of claims 1 to 6, wherein the touch substrate is a color filter substrate, and the color filter substrate is provided with a color filter unit.

8. A touch screen, comprising:
an array substrate and a color filter substrate disposed opposite to each other, the color filter substrate comprising an active area and a bezel area located at a periphery of the active area;
a touch element layer disposed on a side of the color filter substrate facing away from the array substrate or a side of the color filter substrate facing toward the array substrate, the touch element layer comprising a plurality of metal pads in its peripheral region; and
a light shielding layer provided at a side of at least one of said plurality of metal pads facing away from the base substrate.

9. The touch screen according to claim 8, wherein an area of the light-shielding layer covers all the metal pads in the peripheral region.

10. The touch screen according to claim 8, wherein a width of the bezel area is 2 to 3.8 mm.

11. The touch screen according to claim 10, wherein a spacing between the light shielding layer and the active area is less than 1.0 mm.

12. The touch screen according to claim 10, wherein the spacing between the light shielding layer and the active area is 0.4 to 0.9 mm.

13. The touch screen according to claim 10, wherein the spacing between the light shielding layer and the active area is 0.5 to 0.8 mm.

14. The touch screen according to claim 10, wherein the spacing between the light shielding layer and the active area is 0.5 to 0.6 mm.

15. A touch screen, comprising:
an array substrate and a color filter substrate disposed opposite to each other, the color filter substrate comprising an active area and a bezel area located at a periphery of the active area; and
a touch element layer disposed at a side of the color filter substrate facing away from the array substrate or a side of the color filter substrate facing toward the array substrate,
wherein the touch element layer comprises an intermediate region and a peripheral region, the peripheral region comprising a plurality of ITO pads instead of metal pads.

16. The touch screen according to claim 15, wherein the intermediate region comprises metal pads and/or ITO pads.

17. The touch screen according to claim 15, wherein a spacing between the ITO pad and the active area is 0.4 to 0.9 mm.

18. A method for manufacturing a touch screen, comprising:
preparing an array substrate and a color filter substrate, the color filter substrate comprising an active area and a bezel area located at a periphery of the active area;
preparing a touch element layer on a side of the color filter substrate facing away from the array substrate or a side of the color filter substrate facing toward the array substrate, the touch element layer comprising a plurality of metal pads in its peripheral region; and
providing a light shielding layer on a side of at least one of said plurality of metal pads facing away from the array substrate.

19. The method according to claim 18, wherein providing the light shielding layer on the side of at least one of said plurality of metal pads facing away from the array substrate comprises providing the light shielding layer on all of said metal pads in said peripheral region.

20. A display device comprising:
a touch substrate according to any one of claims 1 to 7 or a touch screen according to any one of claims 8 to 17; and
a driving device for driving the touch substrate or the touch screen.
